# EUROPEAN PATENT APPLICATION

(11) **EP 0 966 038 A2**
(43) Date of publication of application: **22.12.1999**
(21) Application number: 99304256.3
(22) Date of filing: 01.06.1999
(51) Int. Cl.: H01L 23/495

(54) **Bonding of semiconductor power devices**

(30) Priority: 15.06.1998 US 94940
(71) Applicant: FORD MOTOR COMPANY, Dearborn, MI 48126 (US)
(72) Inventor: Baker, Jay DeAvis, Dearborn, Michigan 48121 (US); Pham, Cuong Van, Sugarland, TX 77479 (US); Hayden, Brian John, Royal Oak, Michigan 48067 (US)
(74) Representative: Messulam, Alec Moses

(57) **Abstract**

There is disclosed herein a semiconductor power device assembly 80 which may be bonded to a circuit board without wirebonding. The device comprises: (a) a bare die semiconductor power device 10 having a top surface 12 and a bottom surface 14; (b) at least one metallic die bump 20 attached to the top surface 12 of the power device 10; (c) a metallic mounting tab 40 having a first portion 42 attached to the bottom surface of the power device; a second portion 44 oriented above, outward from, and generally parallel with the first portion and having a top surface 46 thereon; and a third portion 48 connecting the first portion 42 with the second portion 44; and (d) a metallic mounting tab bump 50 attached to the top surface 46 of the second portion 44. The top surface 46 of the second portion 44 is oriented generally coplanar with the top surface 12 of the power device 10.

## Description

The present invention relates generally to semiconductor power devices, and more particularly to a semiconductor power device which may be bonded to a circuit board.

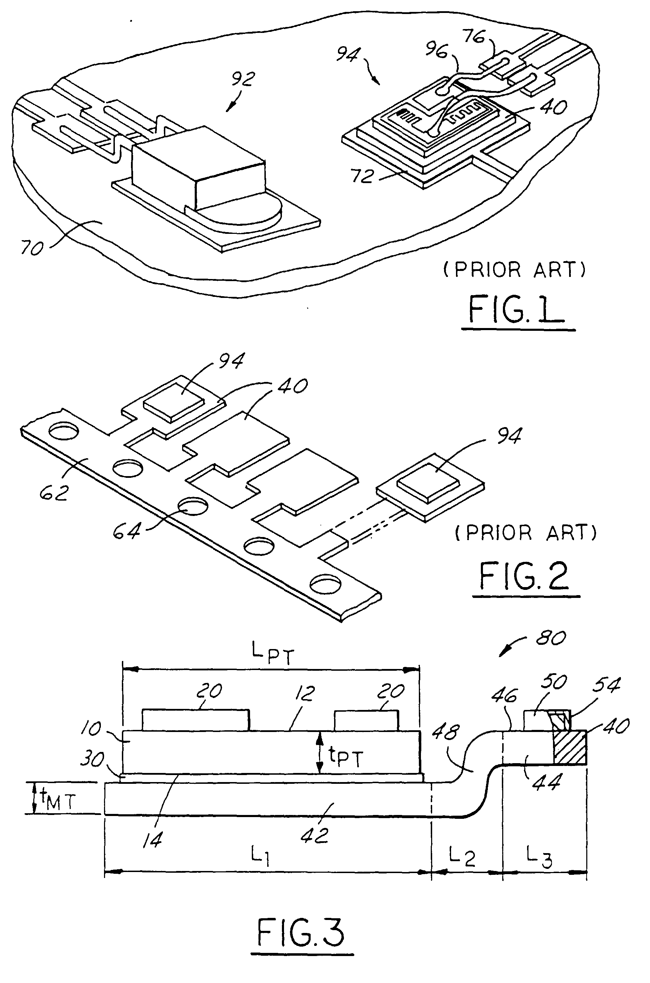

In the field of electronics manufacturing, semiconductor power devices (SPDs) such as power transistors are typically provided in either of two forms: (1) as a conventional packaged component 92, or (2) as a bare die 94. As illustrated in FIG. 1, packaged power devices 92 (e.g., DPAKs) are typically attached to the circuit board substrate by reflow soldering the component terminations to their respective mounting pads, while bare dies 94 are typically attached by wirebonding.

In the latter of these two approaches, the bottom surface of the SPD is either directly attached to a substrate mounting pad, or, more commonly, the bottom surface is first attached to a metallic mounting tab 40 and the assembly is then attached to the substrate mounting pad 72. The mounting tab serves as a heat sink/heat conduit for the die, and also (where applicable) as an electrical conductor between the metallised bottom of the die and the mounting pad 72 onto which the die is attached.

Multiple mounting tabs are usually produced as part of a stamped copper leadframe 60 comprising a generally straight carrier strip 62 with individual mounting tabs 40 extending out orthogonally therefrom, as shown in FIG. 2. A bare die 94 is then attached to each mounting tab 40, and each die/tab sandwich is then singulated from the carrier strip 62. After singulation, each die/tab sandwich is attached to the substrate 70 with the tab portion attached to a respective mounting pad 72, followed by wirebonding one or more sites on the top surface of the die to a respective one or more other mounting pads 76.

Atop the semiconductor die are one or more aluminium bond pads, each of which is typically connected to a corresponding substrate mounting pad 76 by a length of wirebonding wire 96. The end of the wire 96 attached to the aluminium die bond pad may have a "ball" formed thereon (the formation and use of which is well known in the art), or the end of the wire may be attached without a ball (i.e., wedge bonded). In either case, the attachment of each wire end to the die bond pads and substrate mounting pads is achieved using thermocompression, thermosonic, or ultrasonic bonding, as is well known in the art. The wire 96 used in wirebonding is usually either ≤2-mil-diameter gold or 5- to 20-mil diameter aluminium; more specifically, for connections made to power devices such as power transistors, the thicker aluminium wire is preferred over the thinner gold wire.

Although wirebonding is widely used in the electronics manufacturing industry for connecting SPDs to substrates, it is desirable for process simplification, reliability, cost, and other reasons to find suitable alternatives to wirebonding, while avoiding the use of conventional packaged SPDs.

The present invention provides a semiconductor power device assembly which may be bonded to a substrate without resort to wirebonding or use of conventional packaged SPDs. The assembly comprises: (a) a bare die semiconductor power device having a top surface and a bottom surface; (b) at least one metallic die bump attached to the top surface of the power device; (c) a metallic mounting tab having a first portion attached to the bottom surface of the power device; a second portion oriented above, outward from, and generally parallel with the first portion and having a top surface thereon; and a third portion connecting the first portion with the second portion; and (d) a metallic mounting tab bump attached to the top surface of the second portion. The top surface of the second portion is oriented generally coplanar with the top surface of the power device.

It is an advantage that the present invention may be used to connect bare die semiconductor devices to circuit board substrates without the use of wirebonding and without resort to conventional packaged components.

The invention will now be described, by way of example, with reference to the accompanying drawings, in which:
FIG. 1 is a perspective view of packaged and wirebonded SPDs according to the prior art;
FIG. 2 is a perspective view of a mounting tab/carrier strip stamping according to the prior art;
FIGS. 3-4 are side and perspective views, respectively, of an SPD according to the present invention;
FIGS. 5-6 are perspective and side views, respectively, of a mounting tab/carrier strip stamping according to the present invention;
FIGS. 7A-D are side views of an SPD before die-bonding, after die-bonding, after singulation, and after bonding to a substrate, respectively, according to the present invention;
FIG. 8 is an underside perspective view of an SPD according to the present invention;
FIG. 9 is a side section view of a die bump according to the present invention; and
FIGS. 10-11 are side and perspective views, respectively, of an SPD having specially designed third portions.

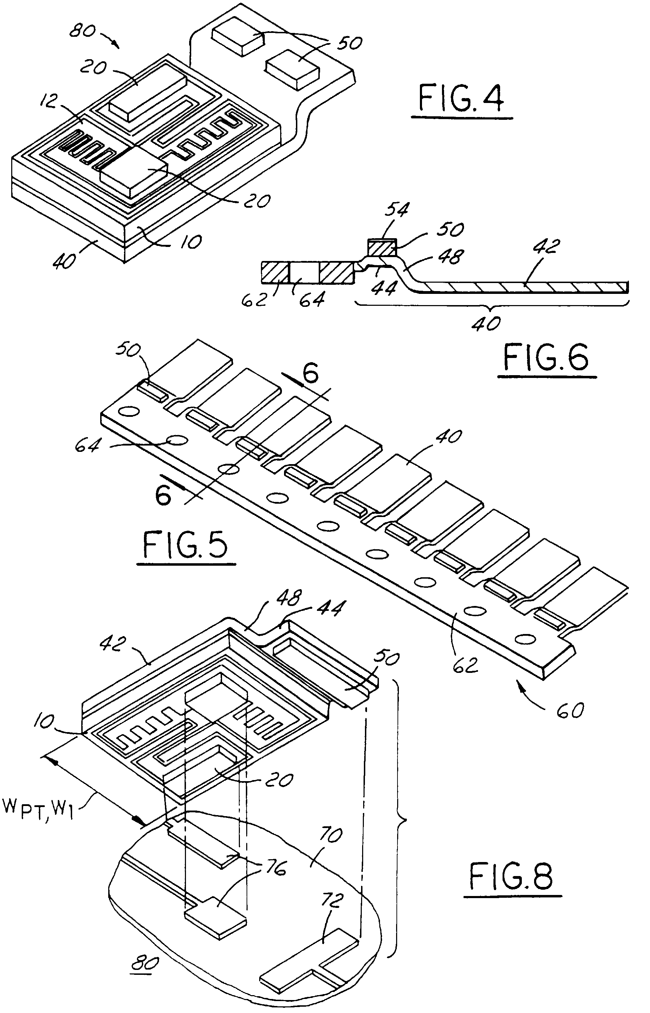

Referring now to the drawings, FIGS. 3-4 show a semiconductor power device assembly 80 which may be bonded to a circuit board without wirebonding. The device comprises; (a) a bare die semiconductor power device 10 having a top surface 12 and a bottom surface 14; (b) at least one metallic die bump 20 attached to the top surface 12 of the power device 10; (c) a metallic mounting tab 40 having a first portion 42 attached to the bottom surface of the power device; a second portion 44 oriented above, outward from, and generally parallel with the first portion and having a top surface 46 thereon; and a third portion 48 connecting the first portion 42 with the second portion 44; and (d) a metallic mounting tab bump 50 attached to the top surface 46 of the second portion 44. The top surface 46 of the second portion 44 is oriented generally coplanar with the top surface 12 of the power device 10.

To assist the reader in understanding the present invention, all reference numbers used herein are summarised in the table below, along with the elements they represent:
- 10 =: Bare die semiconductor power device (SPD)
- 12 =: Top surface of SPD
- 14 =: Bottom surface of SPD
- 16 =: Aluminium bond pads
- 18 =: Barrier/seed layer(s)
- 20 =: Die bump
- 24 =: Outer metal layer on die bump
- 30 =: High-temperature die-bonding solder
- 40 =: Mounting tab
- 42 =: First portion of mounting tab
- 44 =: Second portion of mounting tab
- 46 =: Top surface of second portion
- 48 =: Third portion of mounting tab (tie bars)
- 50 =: Mounting tab bump
- 54 =: Outer metal layer on mounting tab bump
- 60 =: Leadframe
- 62 =: Carrier strip of leadframe
- 64 =: Sprocket holes in carrier strip
- 70 =: Dielectric substrate (e.g., circuit board)
- 72 =: Mounting pad to which die bottom is soldered
- 74 =: Metallic coating on mounting pad
- 76 =: Mounting pad to which die is wirebonded
- 80 =: Power device/mounting tab/bump assembly
- 92 =: Packaged SPD (prior art)
- 94 =: Bare die SPD (prior art)
- 96 =: Wirebond wire
- L_{PT} =: Length of die
- W_{PT} =: Width of die
- t_{PT} =: Thickness of die
- L₁ =: Length of first tab portion
- L₂ =: Length of second tab portion
- L₃ =: Length of third tab portion
- W₁ =: Width of first tab portion
- t_{MT} =: Thickness of mounting tab
- t₄₈ =: Thickness of third portion/tie bar(s)
- W_{CS} =: Width of carrier strip
- t_{CS} =: Thickness of carrier strip

The bare die power device 10 may be a power transistor, MOSFET, triode, or any other bare die component that is otherwise normally wirebonded to a substrate. The bare die is usually silicon, but may also be germanium, gallium arsenide, or any other semiconductor material.

On the top surface 12 of the die 10 are one or more aluminium bond pads 16 for connecting the die 10 to mounting pads on the adjacent substrate. The bottom surface 14 of the die is typically metallised and may be used as an electrical connection point for the die as well. For example, bare die power transistors typically have two aluminium bond pads on the top surface 12 and a metallised bottom surface 14, thus providing three points (i.e., emitter, base, and collector) at which the die may be electrically connected with its environment.

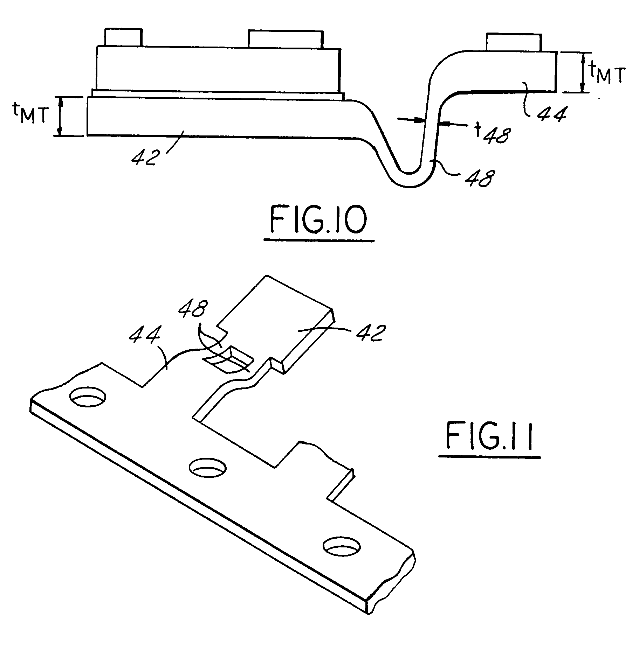

The bump(s) 20 on the die 10 (as well as those 50 on the mounting tab 40) may be made from a variety of different metals, such as copper, nickel, gold, high temperature solder, and alloys containing one or more of these metals. The bumps 20/50 typically are generally spherical, cylindrical, or rectangular masses, and may be formed by plating, sputtering, ball bumping, or other well-known metal deposition means. The size of the bumps should be optimised to balance two conflicting concerns: (1) the bumps should be made as small as practicable in order to minimise the mismatch in the coefficients of thermal expansion (CITE) among the die, bump, pad, and solder materials, and (2) the bumps should be made as large as practicable in order to maximise the heat dissipation from the die, through the bumps, and into the mounting pads. Gold bumps may be directly bonded onto the aluminium bond pads 16 by thermocompression, for instance, but it is preferred that the bumps 20/50 be made of copper or high temperature solder rather than gold because the bumps are typically so large (e.g., 20- to 40-mil diameter spherical masses for the die bumps 20), thus making copper or solder more cost-effective than gold in this application. Atop the aluminium bond pads 16, one or more barrier/seed layers 18 of tungsten, titanium, chromium/copper/chromium, and/or other metals may be plated, sputtered, or otherwise deposited. Such layers 18 facilitate the joining/plating of the typical copper bump 20 to the aluminium bond pad 16. The copper bump 20 itself is typically plated onto the barrier/seed layers 18. A typical die bump configuration is illustrated in FIG. 9.

Each die bump 20 and tab bump 50 may further include a metallic coating or outer layer 24/54 thereon, as illustrated in FIGS. 3 and 9. This coating 24/54 may be gold, tin-gold solder (preferably eutectic), tin-lead solder (preferably eutectic), nickel (with a coating of gold thereon), silver, tin, or the like. This outer coating 24/54 facilitates bonding the (typically) copper bumps 20/50 to the copper mounting pads 72/76 on the substrate 70. If the assembly 80 is to be reflow soldered to the substrate 70, then it is preferred that the coating 24/54 be tin-gold solder; this coating serves as both an oxidation barrier and a reflowable solder. On the other hand, if the assembly 80 is to be bonded to the substrate 70 by thermocompression, thermosonic bonding, or ultrasonic bonding, then it is preferred that the coating 24/54 comprise a first layer of nickel over the copper bump, and a second layer of gold atop the nickel.

The die 10 is usually bonded to the mounting tab 40 by soldering the bottom surface 14 of the die to the top surface of the first portion 42 of the mounting tab, using a high-temperature die-bonding solder 30. This solder 30 may be high-lead-content tin-lead (e.g., Sn5/Pb95, Sn10/Pb90), tin-silver (e.g., Sn95/Ag5), tin-antimony (e.g., Sn95/Sb5), tin-lead-silver (e.g., Sn10/Pb88/Ag2), or any other suitable solder.

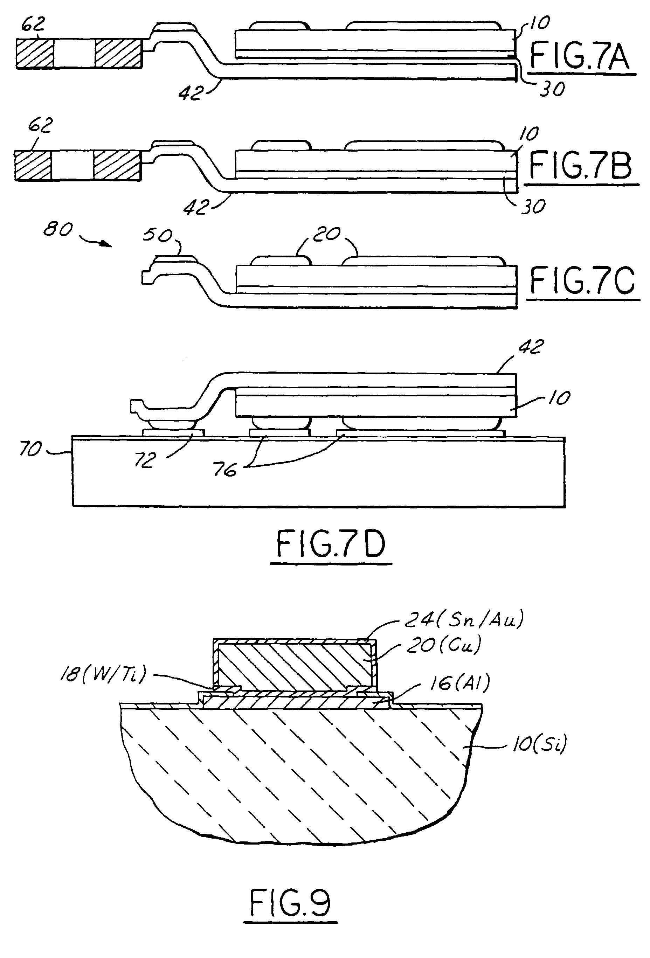

The mounting tab 40 is typically made of copper, with the first portion 42 typically conforming in shape and size with the bottom surface 14 of the die 10. The overall profile/shape of the tab 40 is unique and is specially designed for use in the present invention. With the first, second, and third portions 42/44/48 arranged as shown in FIGS. 3, 4 and 8 and as described above, the assembly 80 may be oriented with respect to the substrate 70 and corresponding mounting pads 72/76 as shown in FIGS. 7D and 8. The orientation of the first and second portions 42/44 with respect to each other should be such that the top surface 46 of the second portion 44 is generally coplanar with the top surface 12 of the die 10. This orientation may be achieved by proper control of the stamping and forming process for the leadframe 60 or mounting tab 40.

The third portion 48 may have a thickness t₄₈ and/or width thinner than that of the first and/or second portions 42/44, and/or may comprise two or more narrowed tie bars (with a hole between each tie bar) rather than a single tab, and/or may be designed with a somewhat undulated or serpentine profile, as variously illustrated in FIGS. 10 and 11. These features may be used to help reduce or eliminate any deflection or stress caused by the differing coefficients of thermal expansion (CITE) for the different materials involved (e.g., silicon die, copper tab, gold bumps, etc.).

The mounting tab second portion 44 may have a single bump 50 thereon, as illustrated in FIG. 8, or it may have two or more bumps 50, as shown in FIG. 4. When a single bump 50 is used, it preferably extends across at least half the width of the second portion 44 and is generally centred across this width, in order to lend stability to the assembly 80 when mounted atop the substrate 70. The tab bump(s) 50 is/are preferably made of the same material(s) as the die bump(s) 20 (e.g., copper).

The substrate 70 to which the die assembly 80 is connected is typically a printed circuit board (PCB). The substrate/PCB 70 may be rigid (e.g., epoxy/glass FR-4, alumina, etc.) or flexible (e.g., polyester, polyimide, or polyetherimide flex material). In either case, the substrate 70 includes a network of conductive (usually copper) circuit traces and mounting pads 72/76 thereon; each die bump 20 and tab bump 50 is attached to a respective one of these mounting pads 72/76. The pads 72/76 may include a coating or layer 74 thereon of gold, tin-gold solder, tin-lead solder, nickel (with a layer of gold thereon), silver, tin, organic solder preservative (OSP) such as benzotriozole, or the like. These coatings/layers serve as oxidation barriers (i.e., to prevent the copper pads 72 from oxidation) and also facilitate bonding of the bumps 20/50 to the pads 72.

A specific application of the present invention is shown in FIGS. 3 and 8. Here, the bare die 10 is a power transistor whose dimensions are: L_{PT} = 120 mils, W_{PT} = 120 mils, and t_{PT} = 8 mils. The mounting tab 40 is made of copper and has dimensions: L₁ = 150 mils; W₁ = 150 mils; L₂ = 50 mils; L₃ = 50 mils; t_{MT} = 20 mils; and t₄₈ = 10 mils. The carrier strip portion 62 of the leadframe 60 is made of copper with about 2% iron added to increase the strength and durability so that the leadframe 60 may be fed through a machine/process (using sprocket holes 64) to singulate and then pick-and-place each individual die/tab assembly 80. The carrier strip dimensions are: W_{CS} = 190 mils and t_{CS} = 40 mils. The length of the overall leadframe 60 can be as long as desired (or as long as the equipment used can accommodate).

In the present example, a copper sheet from which the tabs 40 may be punched, and a copper/iron sheet from which the carrier strip may be punched, are electron-beam (or otherwise) welded, followed by a punching/stamping operation for forming the tab perimeters, carrier strip perimeters, and sprocket holes, and further followed by a forming operation to create the unique mounting tab profile of the present invention. As an alternative to the foregoing example, the entire leadframe 60 (i.e., mounting tabs 40 and carrier strip 62) may be stamped from a single sheet of metal (e.g., 20-mil-thick copper). The steps of (1) die-bonding the bare semiconductor die 10 to the mounting tab first portion 42 (see FIGS. 7A and 7B), (2) forming bumps 20/50 on the die 10 and mounting tab second portion 44, and (3) forming the mounting tab profile so as to create the first, second, and third portions 42/44/48 as illustrated in the drawings, may be performed in the order desired, depending on equipment, process, and other manufacturing constraints well known in the art.

Once these steps are completed, the individual assemblies 80 may be singulated from the leadframe 80 (see FIG. 7C) and then pick-and-placed onto respective mounting pads 72/76 atop the dielectric substrate 70 (see FIG. 7D). As illustrated in FIGS. 7C, 7D and 8, once the assemblies 80 are fabricated, they may be "inverted" with the bumps 20/50 facing the substrate 70 and aligned with their respective mounting pads 72/76. The die/tab assembly may then be placed in contact with the substrate/mounting pads (while maintaining the aforementioned alignment) and the assembly bonded to the substrate by (1) thermocompression, thermosonic, or ultrasonic bonding, or by (2) reflowing the solder/coating 74 that may be present on the pads 72/76 and/or reflowing the outer layer 24/54 that may be present on the bumps 20/50. For the case of reflow processing, multiple individual assemblies 80 may be carried on a tape-and-reel and populated on a substrate using pick-and-place equipment, just as any other SMC device.

It should be noted that the arrangement of the mounting pads 72/76 in the present invention is quite different from that found in the prior art wirebonding approach. In the prior art approach illustrated in FIG. 1, a given mounting pad 72 is located directly beneath the bottom 14 of the die, while two other pads 76 (to which the die I/O pads are wirebonded) are located adjacent to the die. In contrast, the orientation of the mounting pads 72/76 in the present invention is completely opposite that of the prior art, as illustrated in FIGS. 7D and 8. That is, the mounting pads 76 to which the die I/O pads are bonded are positioned directly "beneath" the die, and the mounting pad 72 to which the metallised "bottom" 14 of the die is attached (through the tab 40) is located adjacent the die. Thus, the arrangement of the mounting pads 72/76 on the substrate 70, and the orientation of the pads 72/76 with respect to their associated bond sites (i.e., bumps 20/50), are not only unique with respect to the prior art but are both completely contraindicated with respect thereto.

Various other modifications to the present invention will, no doubt, occur to those skilled in the art to which the present invention pertains. For example, although the die 10 has been described herein as a "power device", it should be apparent that the present invention is equally applicable to low-power devices for which an alternative to wirebonding is desired. Also, it should be noted that the term "SPD" has been used herein to variously denote a bare semiconductor die alone, a bare die bonded to a mounting tab, and a die/tab assembly bonded to a substrate; in each use of the term "SPD", it should be clear from the context which of these combinations are being referred to. Additionally, it should be apparent that the die 10 may be bumped while in wafer form before die sawing/individuation, or may occur afterward (either before or after mounting the die 10 to the tab 40).

## Claims

1. A semiconductor power device assembly, comprising:
a bare die semiconductor power device (10) having a top surface (12) and a bottom surface (14);
at least one metallic die bump (20) attached to the top surface (12) of said power device (10);
a metallic mounting tab (40) having a first portion (42) attached to the bottom surface (14) of said power device (10); a second portion (44) oriented above, outward from, and generally parallel with said first portion (42) and having a top surface (46) thereon; and a third portion (48) connecting said first portion (42) with said second portion (44); and
a metallic mounting tab bump (50) attached to the top surface (46) of said second portion (44);
wherein the top surface (46) of said second portion (44) is generally coplanar with the top surface (12) of said power device (10).

2. A semiconductor power device assembly according to claim 1, wherein said first portion of said mounting tab generally conforms in shape and size with said bottom surface of said power device.

3. A semiconductor power device assembly according to claim 1, wherein each die bump and mounting tab bump is made of tin/lead solder, copper, nickel, gold, or alloys thereof.

4. A semiconductor power device assembly according to claim 3, further comprising a coating on each die bump and mounting tab bump, wherein said coating is selected from the group consisting of: tin-gold solder; tin-lead solder; nickel, with another coating of gold thereon; silver; and tin.

5. A semiconductor power device assembly according to claim 1, wherein each die bump and mounting tab bump is made of copper with a coating thereon of tin-gold solder.

6. A semiconductor power device assembly according to claim 1, wherein each die bump and mounting tab bump is made of copper with a first coating thereon of nickel and a second coating of gold on said first coating.

7. A semiconductor power device assembly according to claim 1, wherein said mounting tab is made of copper.

8. A semiconductor power device assembly according to claim 1, wherein said mounting tab bump extends across at least half the width of said second portion.

9. A semiconductor power device assembly according to claim 1, further comprising a high-temperature die-bonding solder disposed between and bonding together said first portion of said mounting tab and said bottom surface of said power device.

10. A semiconductor power device assembly according to claim 1, further comprising a dielectric substrate having conductive mounting pads thereon, wherein each die bump and mounting tab bump is attached to a respective one of said mounting pads.
